# DEMANDE DE BREVET EUROPEEN

(11) **EP 1 288 345 A2**
(43) Date de publication de la demande: **05.03.2003**
(21) Numéro de dépôt: 02292088.8
(22) Date de dépôt: 22.08.2002
(51) Int. Cl.: C30B 11/00, C30B 29/48

(54) **Dispositif d'homogeneisation de temperature de deux charges solides dans une cartouche de solidification**

(30) Priorité: 24.08.2001 FR 0111096
(71) Demandeur: COMMISSARIAT A L'ENERGIE ATOMIQUE, 75752 Paris Cédex 15 (FR); CENTRE NATIONAL D'ETUDES SPATIALES, 75001 Paris (FR)
(72) Inventeur: Salvi, Charles, 38000 Grenoble (FR); Garandet, Jean-Paul, 38000 Grenoble (FR); Borgis, André, 38000 Grenoble (FR)
(74) Mandataire: Ilgart, Jean-Christophe

(57) **Abrégé**

Le dispositif d'homogénéisation de températures à l'extrémité d'un creuset (1) de solidification, et qui permet de contrôler le processus à l'aide d'un circuit à électrodes (15, 16) mesurant un effet thermoélectrique entre les charges, est globalement isolant de l'électricité, notamment en aluminium revêtu par anodisation, tout en restant bon conducteur thermique. Le matériau intercalaire entourant les électrodes (15 et 16) et les parties solides des charges (7 et 8) devient inutile, et le dispositif plus efficace.

## Description

Le sujet de cette invention est un dispositif d'homogénéisation de température de deux charges solides dans une cartouche de solidification, notamment utile pour réaliser des croissances contrôlées de cristaux.

Les appareils existants comprennent en général une cartouche composée principalement d'un creuset évidé d'au moins un alvéole dans lequel une charge à solidifier est versée, ainsi qu'un four entourant le creuset et mobile par rapport à lui. Pour solidifier la charge, on dégage une longueur toujours plus importante du creuset en reculant progressivement le four et laissant la charge présente dans cette longueur se refroidir. Une précaution usuelle consiste à déposer un germe ayant la structure cristalline recherchée à l'extrémité de l'alvéole qui est dégagé en premier du germe en imitant sa structure cristalline.

Un problème communément rencontré, notamment avec les corps enrichis d'un dopant, est de contrôler la composition des sections de la charge qui se solidifient successivement, afin de vérifier qu'elles gardent la bonne composition cristalline demandée. Un procédé de contrôle satisfaisant porte le nom de Seebeck et comporte quelques variantes. Il est fondé sur les propriétés thermodynamiques des mélanges mis à solidifier et sur l'exploitation d'un phénomène thermoélectrique.

Un mélange se solidifie à une température qui dépend de la composition de la fraction se solidifiant. Si on ajoute une charge servant de témoin dans un autre alvéole à côté de la charge principale, se solidifiant avec elle et ayant une composition connue avec certitude, telle que le corps de base de la charge principale à l'état pur, une mesure indirecte de la température de solidification de la charge principale devient possible en disposant deux électrodes sur les portions solidifiées des charges, en mesurant la différence de potentiel entre ces deux électrodes dans un circuit qui les relie, et en rapportant cette différence de potentiel à des résultats d'étalonnage.

La qualité de la mesure est conditionnée au respect d'un certain nombre de précautions, parmi lesquelles on insistera ici sur l'homogénéité des températures aux extrémités des charges solides, là où les électrodes de mesure entrent en contact avec les charges, faute de quoi des effets thermoélectriques parasites sont produits et affectent le signal de mesure. Le dispositif d'homogénéisation est donc destiné à rapprocher autant que possible l'une de l'autre les températures aux extrémités des deux charges, alors que les températures sont en général différentes à des endroits correspondants des charges. Le dispositif d'homogénéisation disposé en prolongement du creuset comprend un bloc bon conducteur de la chaleur qu'on évide d'alvéoles prolongeant ceux du creuset pour qu'il loge les électrodes de mesure et les extrémités des charges. Malheureusement, les matériaux conducteurs thermiques sont aussi conducteurs de l'électricité et provoqueraient des courts-circuits entre les électrodes si des précautions supplémentaires n'étaient pas prises. Dans l'art connu, les alvéoles du dispositif d'homogénéisation sont couverts d'un matériau intercalaire isolant électrique qui empêche un contact direct entre les électrodes et la masse du dispositif d'homogénéisation. Une conséquence défavorable de cette disposition est qu'une barrière thermique est créée autour des extrémités des charges, ce qui réduit l'effet d'homogénéisation. Les dispositifs existants ne sont pas très satisfaisants en pratique.

Un but de l'invention est de proposer un dispositif d'homogénéisation qui permette de se passer du matériau intercalaire.

Conformément à l'invention, le dispositif d'homogénéisation est isolant de l'électricité. La contradiction avec la remarque précédente que des conducteurs thermiques ne peuvent être que conducteurs électriques n'est qu'apparente : dans les réalisations essentielles de l'invention, le dispositif se compose d'un conducteur thermique dans sa masse et d'un revêtement isolant électrique qui couvre au moins ses surfaces en contact avec les électrodes et les charges. Ainsi, le dispositif devient impuissant à transmettre les courants électriques. Sa conductivité thermique est évidemment réduite, mais de façon beaucoup moindre que dans la solution antérieure en raison de la finesse du revêtement et de son intimité avec la masse du dispositif. L'invention englobe ainsi des corps hétérogènes dans leur composition ou leur structure métallurgique ou cristallographique, mais ne concerne que des corps unitaires physiquement, contrairement à la conception antérieure. Dans tous les cas, le matériau intercalaire introduit dans les alvéoles du dispositif d'homogénéisation devient inutile.

Les revêtements peuvent être formés de différentes manières, mais les dépôts par voie chimique ou électrolytique sont essentiellement envisagés car ils permettent de déposer des revêtements fins et réguliers, et surtout dépourvus de fissures susceptibles de rompre l'isolation électrique. Dans une réalisation particulière, le dispositif est en aluminium, plutôt qu'en cuivre comme dans les conceptions connues, et son revêtement est de l'aluminium anodisé.

Une autre amélioration proposée concerne la forme du dispositif d'homogénéisation. Conformément à une variante favorable de l'invention, elle est formée de sections ou d'épaisseurs différentes se succédant dans une direction correspondant à l'extension des alvéoles. Les sections épaisses forment des disques de dissipation thermique, alors que les sections minces réduisent la transmission de chaleur le long des alvéoles et favorisent la dissipation par les disques.

On comprend donc l'intérêt de ce dispositif d'homogénéisation dans une cartouche de solidification de charges comportant en particulier un creuset comprenant des alvéoles de logement des parties liquides des charges, ainsi qu'un conducteur reliant les parties liquides, pour appliquer le procédé de contrôle dû à Seebeck.

D'autres aspects de l'invention seront maintenant décrits en liaison aux figures, parmi lesquelles :

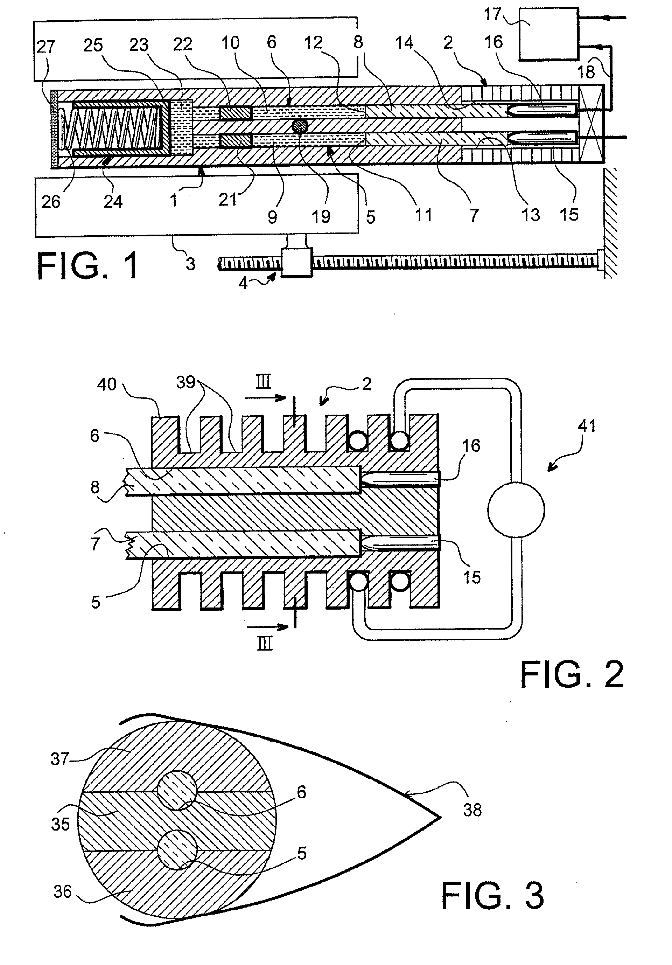

- la figure 1 est une vue d'ensemble d'une cartouche de solidification équipée de l'invention, et
- les figures 2 et 3 sont des vues du dispositif, respectivement selon la disposition de la figure 2 et selon la coupe III-III de la figure 2.

Un four de solidification comprend un creuset 1 élancé prolongé par un dispositif homogénéisateur 2 de température. Un four 3 entoure une portion du creuset 1 et se déplace en le dégageant progressivement à partir de régions proches de l'homogénéisateur 2 pendant le processus de solidification. Il peut à cet effet être uni à un support fixe par un dispositif de liaison 4 comprenant une glissière, une vis sans fin ou tout autre moyen analogue. Le mouvement de dégagement du four 3 est assuré par un dispositif de commande non représenté.

Le creuset 1 comprend deux alvéoles 5 et 6 longitudinaux et parallèles pour une charge principale et une charge de référence qu'on solidifie. Les charges comprennent chacune une portion solidifiée 7 ou 8 et une portion liquide 9 ou 10 séparées par une interface 11 ou 12 pouvant être à des endroits différents. Les portions solidifiées 7 et 8 sortent des alvéoles 5 et 6 pour pénétrer dans les alvéoles 13 et 14 de l'homogénéisateur 2 qui prolongent respectivement les précédents. Deux électrodes 15 et 16 en pointe s'étendent aux bouts des alvéoles 13 et 14 et sont reliées à un dispositif de mesure de tension 17 par un circuit électrique 18 qui les unit. De plus une électrode 19 passive s'étend dans la masse du creuset 1, entre les alvéoles 5 et 6 de manière à y déboucher et à baigner les portions liquides 9 et 10. L'homogénéisateur 2 est en général un bloc de matière conductrice de chaleur pour porter les extrémités des portions solidifiées 7 et 8 à une même température, comme on l'a mentionné.

Deux pistons 21 et 22 glissent à l'arrière des alvéoles 5 et 6 pour confiner les portions liquides 9 et 10. Derrière eux s'étend une masse liquide 23 qui occupe le reste des alvéoles 5 et 6 ainsi qu'une partie adjacente d'un logement cylindrique 24 évidé tout à l'arrière du creuset 1 et dans lequel débouchent les deux alvéoles 5 et 6. La masse liquide 23 est confinée dans une partie du logement 24 par un plateau de compression 25 repoussé par un ressort 26 comprimé entre ce plateau 25 et un couvercle 27 du logement 24, qui est assujetti au creuset 1. Ainsi, la compression du ressort produit une pression dans la masse liquide 23, qui est transmise aux portions liquides 9 et 10 des charges par les pistons 21 et 22. Cette pression varie peu à travers le processus de solidification, puisque le ressort 26 ne subira qu'une détente réduite et que les variations de pression s'égalisent d'ailleurs d'un alvéole 5 et 6 à l'autre à travers la masse liquide 23.

On passe maintenant à la description du dispositif d'homogénéisation 2. Il comprend un noyau 35 encadré par deux parts périphériques 36 et 37 qui l'enserrent au moyen d'une pince 38, d'un système à vis ou d'un moyen équivalent, de préférence élastique. Les jonctions du noyau 35 et des parts 36 et 37 passent respectivement par les alvéoles 5 et 6 et leur sont donc limitrophes, le noyau 35 étant limitrophe des deux alvéoles 15 et 16 et les parts périphériques 36 et 37 d'un seul. Ils sont construits en aluminium et ont été anodisés de sorte que leur surface, et notamment celle des alvéoles 5 et 6, est isolante de l'électricité. Le dispositif 2 est formé de sections alternativement fines 39 et épaisses 40 ; celles-ci forment des disques de dissipation thermique et celles-la des barrages à l'écoulement de chaleur autour des portions solidifiées 7 et 8 des charges. Même si les températures des charges sont assez différentes à l'entrée de l'homogénéisateur 2, une uniformisation bien meilleure que dans la conception antérieure est obtenue aux électrodes 15 et 16. En cas de besoin, un circuit thermique 41, souvent appelé micro-four dans cette technique, est disposé autour des électrodes 15 et 16 pour égaliser mieux encore leur température. Il peut comprendre une spire chauffante de nature électrique ou fluide, ou au contraire une spire de refroidissement par un fluide. Il est commandé d'une façon ordinaire qu'il est donc inutile de rappeler ici. On notera cependant que, dans l'art antérieur où l'égalisation des extrémités des charges est moins bonne, un micro-four indépendant doit être placé près de chaque électrode 15 et 16 et être commandé indépendamment, ce qui nécessite un asservissement beaucoup plus compliqué, de même que l'agencement global. Comme un seul micro-four 41 devient nécessaire, il est en pratique possible de construire un homogénéisateur 2 beaucoup plus petit, ce qui est apprécié dans bien des situations, notamment pour des fabrications dans l'espace.

## Revendications

1. Dispositif d'homogénéisation (2) de température de deux charges solides (7, 8), comprenant deux alvéoles (13, 14) pour les charges et pour deux électrodes (15, 16) de prise de potentiel des charges, **caractérisé en ce qu'**il est isolant électrique et comprend des sections d'épaisseurs différentes (39,40 ) se succédant dans une direction commune d'extension des alvéoles.

2. Dispositif d'homogénéisation de température selon la revendication 1, **caractérisé en ce qu'**il est composé d'un conducteur thermique revêtu d'un isolant électrique.

3. Dispositif d'homogénéisation de température selon la revendication 2, **caractérisé en ce qu'**il est en aluminium anodisé.

4. Dispositif d'homogénéisation de température selon l'une quelconque des revendications 1 à 3, **caractérisé en ce qu'**il comporte un noyau (35) limitrophe des deux alvéoles, des parts périphériques (36, 37) limitrophes respectivement d'un des alvéoles, et des moyens élastiques (38) de pressage des parts périphériques contre le noyau.

5. Dispositif d'homogénéisation de température selon l'une quelconque des revendications 1 à 4, **caractérisé en ce qu'**il fait partie d'une cartouche de solidification des charges comportant un creuset (1) comprenant des alvéoles (5, 6) de logement de parties liquides (9, 10) des charges, et un conducteur (19) reliant les parties liquides.
